(19)

Europäisches
Patentamt
European
Patent Office
Office européen
des brevets

(11) **EP 4 350 441 A1**

(12) **EUROPEAN PATENT APPLICATION**

(43) Date of publication:
**10.04.2024 Bulletin 2024/15**

(21) Application number: **22200163.8**

(22) Date of filing: **06.10.2022**

(51) International Patent Classification (IPC):
**G03F 7/20** (2006.01)        **G03F 7/40** (2006.01)

(52) Cooperative Patent Classification (CPC):
**G03F 7/40; G03F 7/70625**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(71) Applicants:
• **Imec VZW**
  **3001 Leuven (BE)**

• **Katholieke Universiteit Leuven**
  **3000 Leuven (BE)**

(72) Inventors:
• **SEVERI, Joren**
  **3000 Leuven (BE)**
• **DE SIMONE, Danilo**
  **3000 Leuven (BE)**

(74) Representative: **Winger**
  **Mouterij 16 bus 101**
  **3190 Boortmeerbeek (BE)**

(54) **STATE TRANSITION TEMPERATURE OF RESIST STRUCTURES**

(57)    A method for determining a value representative of a state transition temperature of a resist structure (91, 92), formed of a resist material and having predetermined dimensions, on an underlayer material (90), the method comprising: receiving (104) data earlier obtained, said data representing a correlation between a second value for a measure representative of a spatial feature of at least one resist structure (91, 92) of each of a plurality of entities (9, 93) after applying a heat treatment, and a temperature at which said heat treatment is applied, each entity (9, 93) comprising the at least one resist structure (91, 92), formed of the resist material and having said predetermined dimensions before said heat treatment, on the underlayer material (90), and wherein said measure has a first value before said heat treatment, and determining (105), from said correlation, said value representative of the state transition temperature, for which, when the heat treatment would be performed at such temperature, said second value differs by a predetermined amount from said first value.

FIG. 5

Processed by Luminess, 75001 PARIS (FR)

EP 4 350 441 A1

**Description**

**Technical field of the invention**

The present invention relates to the field of resists. More concretely, the present invention relates to determining the state transition temperature, e.g., glass transition temperature, of resist structures.

**Background of the invention**

Over the past few decades, lithography has seen a drastic resolution improvement enabled by three main factors: (1) the reduction of the imaging source wavelength $\lambda$, (2) the increase in the lens numerical aperture (NA), and (3) the reduction of the process-related ki-factor. With these factors, the smallest possible half-pitch (HP), i.e., half the minimum center-to-center distance spacing (or pitch) between adjacent resist structures, e.g., resist line structures of a resist, may be calculated, using a first Rayleigh equation for resolution:

$$HP = k_1 \cdot \lambda \ / \ NA \qquad\qquad (eq.\ 1)$$

Alternatively, the equation could be formulated with the half-pitch replaced with the minimum width of the resist structures. The width of resist structures is commonly called the critical dimension (CD).

The most recent advancement of the reduction in wavelength is the introduction of Extreme Ultraviolet (EUV) light (13.5 nm) as the leading-edge technology to produce advanced nanoelectronics. The further advancement of EUV lithography (EUVL) is based on introducing a larger NA, from a current value of 0.33, to 0.55 for the so-called high NA EUVL. The increase of the NA corresponds to a physical increase in the size of the lens, enabling it to capture more diffraction orders (i.e., more information) and thus enabling smaller feature sizes, e.g., smaller half-pitches and smaller widths of resist structures.

During the continuous advancement to smaller feature sizes, also a reduction in the height of the resist structures, commonly called the resist film thickness (FT), has occurred. This reduction in height results from the fact that large aspect ratios (height-to-width) could potentially lead to pattern collapse, i.e., collapse of the resist structures, originating from capillary forces during the development and rinse processes. Additionally, with the advancement to high NA EUVL, a possible second reason for the reduction in height is given by a second Rayleigh equation for the depth-of-focus (DoF):

$$DoF = k_2 \cdot \lambda \ / \ (NA^2) \qquad\qquad (eq.\ 2)$$

This equation shows that the DoF scales with the quadratic inverse NA. Hence, the advancement to high NA EUVL will bring along an expected reduction in DoF which will limit the height of resist structures over which the exposure contrast is sufficiently high to enable a good resist patterning performance.

Due to the continuous downscaling of the height of resist structures, the interfacial interaction between the resist structures and the material underlaying the resist structures becomes increasingly dominant. These interactions can influence the behaviour of the resist material, which in turn make design and optimization of resist structures, to enable a good patterning performance, challenging. Changes related to material behaviour that have been reported before include changes in dose-to-size, resist nanopattern line profile and number of nanofailures, and changes in chemical homogeneity of additives comprised in the resist that may cause pattern degradation.

However, the direct measurement of the interactions between the resist structures and the material underlaying the resist, which could allow for quantifying the changes in behaviour of the resist material, is challenging. Therefore, measuring a readily available material property that indirectly correlates with interfacial interactions is wanted.

There is thus still a need in the art for devices and methods that address at least some of the above problems.

**Summary of the invention**

It is an object of the present invention to provide good methods and apparatus that may be used for determining the state transition temperature, e.g., glass transition temperature, of a resist structure.

The above objective is accomplished by a method and apparatus according to the present invention.

It is an advantage of embodiments of the present invention that a value representative of the state transition temperature of the resist structure may be accurately determined. It is a further advantage of embodiments of the present invention that said determination may not require contacting the resist structure with a sensor or an element of a sensor, e.g., an electrode. A method that does not provide contacting is preferred, as contacting itself may influence the state transition temperature, for example, the glass transition temperature. Furthermore, said contacting may damage the resist structure.

It is an advantage of embodiments of the present invention that the obtained value representative of the state transition temperature may provide a good value for the state transition temperature of essentially 1D or 2D structures, such as resist films or resist line structures, which may substantially differ from a state transition temperature of bulk resist material. It is an advantage of embodiments of the present invention that the interaction between the resist and the underlayer material may also be taken into account with respect to a determination of the state transition temperature or a value representative thereof.

It is an advantage of embodiments of the present invention that said state transition temperature may be used for deriving information on interactions between the resist structure and a material underlaying the resist structure, i.e., an underlayer material. It is an advantage of embodiments of the present invention that said state transition temperature may be used for screening materials comprised in the composition of the resist structure, such as additives, types of polymers, or for screening underlayers. It is an advantage of embodiments of the present invention that the interaction between the resist structure and the underlayer material may be optimized.

In a first aspect, the present invention relates to a method for determining a value representative of a state transition temperature, e.g., glass transition temperature, of a resist structure, formed of a resist material and having predetermined dimensions, on an underlayer material. The method comprises:

a) Obtaining data representing a correlation between a second value for a measure representative of a spatial feature of at least one resist structure of each of a plurality of entities after applying a heat treatment, and a temperature at which said heat treatment is applied,
each entity comprising the at least one resist structure, formed of the resist material and having said predetermined dimensions before said heat treatment, on the underlayer material, and wherein said measure has a first value before said heat treatment, and
b) determining, from said correlation, said value representative of the state transition temperature, for which, when the heat treatment would be performed at such temperature, said second value differs by a predetermined amount from said first value.

In some embodiments, obtaining data may be receiving such data, e.g. via a data input port, whereby such data may be obtained earlier, or it may be obtaining such data by measuring it at that moment in time or earlier.

In some embodiments, the spatial feature may be a dimension or a roughness of the resist structure. The dimension may be selected from: a width, i.e., a critical dimension; a length; or a height, i.e., a film thickness. Herein, the width, the length, and the height are perpendicular to each other. The height is perpendicular to a top surface of the underlayer material. Typically, the length is along a longitudinal axis of the resist structure. In embodiments, the spatial feature is a width or a roughness of the resist structure. The width or critical dimension may be relatively straightforwardly determined, which may result in a relatively straightforward determination of the state transition temperature. In preferred embodiments, the spatial feature is a roughness of the resist structure. The inventors have unexpectedly observed that using the roughness as the spatial feature may provide an accurate determination of the value representative of the state transition temperature.

The first value for the spatial feature is typically substantially the same for each resist structure of the plurality of entities. This may be a result of using the same procedure for making each of the plurality of entities. As the measure for each of the plurality of entities has the same value, i.e., the first value, before the heat treatment, any differences with respect to the second value between the different resist structures of the different entities may be assumed to result from the applied heat treatment.

In some embodiments, the predetermined dimensions comprise the width and height of the resist structure. In some embodiments, the predetermined dimensions comprise the length of the resist structure. In embodiments, the predetermined dimensions comprise a half-pitch. In particular when secondary electron microscopy is performed to determine the second value, the half-pitch is preferably constant amongst the plurality of entities, as there are indications that dimensions measured by secondary electron microscopy may be affected by closely-spaced lines.

Each of the at least one resist structures of each entity has, before the heat treatment, substantially the (same) predetermined dimensions. This may be a result of using the same procedure for making each of the plurality of entities.

In some embodiments, the measure representative of the spatial feature is a width, i.e., critical dimension, or a parameter representative of a line width roughness or a line edge roughness, such as a correlation length for the line width roughness or the line edge roughness. The line edge roughness may be defined as the variation, e.g., variance, of a line edge, e.g., of points of the line edge, along a straight line parallel to the line edge in a direction perpendicular to the longitudinal axis in a plane parallel to a top surface of the underlayer material. Herein, the line edge may be the edge between a top surface and a side surface of the resist structure, e.g., of the resist line structure. However, the line edge roughness may also be assumed to be the roughness of the side surface at a predetermined height. The predetermined height may refer to the threshold used in the SEM or MetroLER algorithm, which potentially can be translated to a resist height. The line width roughness may be defined as the variation, e.g., variance, of the width of the resist structure, e.g., of points of the resist structure, along a longitudinal axis of the resist structure, wherein the resist structure is typically a resist line structure. The width is typically determined at a predetermined height, or may possibly be an average width, averaged over the height of the resist structure. Thus, the roughness may quantify a deviation of the resist structure from an ideal resist structure having flat surfaces.

The correlation length of the line width or edge roughness is the length below which the roughness is correlated. Points along the length of the resist structure at distances greater than the correlation length are typically uncorrelated with each other. In preferred embodiments, the measure representative of the spatial feature is a correlation length for a line width roughness or for a line edge roughness. It is an advantage of these embodiments that the correlation length may provide a good measure of the roughness, and may be accurately determined.

In some embodiments, determining said value representative of the state transition temperature comprises fitting a function to the correlation between the second value and the temperature at which the heat treatment is applied. The function may be any function that provides a fit to the data and allows for extrapolating or interpolating from said correlation. For example, the function may be an exponential growth function, a power function, or a polynomial function, the invention not being limited thereto. In preferred embodiments, determining said value representative of the state transition temperature comprises fitting an exponential growth function to the correlation between the second value and the temperature at which the heat treatment is applied. It is an advantage of these embodiments that the reflow temperature, representative of the state transition temperature, may be accurately derived from extrapolation or interpolation from the limited number of data points, i.e., the limited number of temperatures at which the heat treatment was performed for which the second values were determined. In embodiments, the exponential growth function is of the general form:

$$y(x) = A_1 \cdot e^{x/t_1} + y_0 \qquad\qquad \text{(eq. 3)}$$

Herein, x may be the temperature of the heat treatment. Herein, $y_0$ may be the first value for the measure representative of the spatial feature, that is, before application of said heat treatment, wherein yo may be fixed while fitting or may be a fit parameter, i.e., may be varied for optimizing the fit to the data. $A_1$ and $t_1$ may be used as fit parameters.

The first value may be derived from the correlation between the second value and temperature at which said heat treatment is applied, wherein yo is varied while fitting the above equation (eq. 3) to the data. In that case, the $y_0$ obtained from the fit may be assumed to be the first value. Alternatively, the first value may be obtained by measuring the measure representative of the spatial feature, before applying the heat treatment, on at least one of the plurality of entities. Still alternatively, the first value may be obtained by measuring the measure representative of the spatial feature on a reference entity, comprising the at least one resist structure, formed of the resist material and having said predetermined dimensions, on the underlayer material, wherein no heat treatment is applied to said reference entity. In still another example, for example when yo is a dimension, yo may be derived from the predetermined dimensions. For example, when forming the plurality of entities, the process of forming may have been adapted for obtaining resist structures having a particular predetermined width, and yo may be said particular predetermined width. When the first value is determined from measurements or from said predetermined dimensions, the first value, i.e., yo, may be fixed on said first value when fitting the equation above (eq. 3) to the data.

In some embodiments, each entity comprises a wafer on which the resist structure is formed. Said wafer may be any type of wafer, such as a germanium wafer or a silicon wafer. The resist structure is typically formed over a layer to be etched. The layer to be etched may be the wafer, the underlayer material, or a layer formed on the wafer. In embodiments, the underlayer material may be the wafer, or may be part of the wafer. Alternatively, the underlayer material may be a separate material overlaying the wafer. In embodiments, the underlayer material comprises one of: an organic spin-on, comprising organic materials (typically formed of the following elements: C, H, O, S, and/or N); a silicon containing spin-on (formed of at least Si and typically the following elements: C, H, O, S, and /or N); an inorganic underlayer material; or a deposited SiOC, SiON, or SiC.

In some embodiments, the resist material may be any type of material having a state transition temperature, such as materials having different states at different temperatures, e.g., having a glass transition temperature, such as a glass or polymer, e.g., polymer. As is well-known by the skilled person, when heating a material such as the resist material, during the heat treatment, to or above the glass transition temperature, the resist material transitions from a hard and brittle glassy state into a viscous or rubbery state. While in said viscous or rubbery state, the resist material may change shape. For example, the viscosity of the resist material in the viscous or rubbery state may be low enough so that the resist material from the resist structure may flow. As another example, protons present in the resist structure, for example when the resist material is a chemically amplified resist, may be able to move through the resist structure when the resist structure is in the viscous or rubbery state. This may result in changes to the spatial features of the resist structure, e.g., broadening of the resist structure or a change in roughness of the resist structure. Furthermore, the farther above the glass transition temperature the heat treatment, the larger the changes induced in the resist structures during the heat treatment. By determining a difference between the first value, before said heat treatment, and the second value, after said heat treatment, the change in spatial features may be quantified. Typically, the larger the change, the farther the temperature of the heat treatment is above the glass transition temperature, or a value representative thereof. This explanation may be applied to any type of state of a material, wherein, generally, different states have different structures, e.g., different states having different crystal structures, differ.rent states in which the resist structure has a different volume of size, or different states having a different concentration of defects, or different states having different density. Indeed, by increasing the temperature, a material may transition between different states, e.g., undergo a volume change or a size change, or defects may be formed in the material. Defects may refer to internal material defects that lead to a different rearrangement or shape.

In some embodiments, the period during which the heat treatment is performed is similar or substantially the same for each entity. This has the advantage that interpretation of the data may be relatively straightforward. However, this is not essential, and instead, the period may vary between the different entities.

The value representative of the state transition temperature may be a glass temperature or a reflow temperature, e.g., a temperature at which the material comprised in the resist material starts to reflow due to the resist material being in a viscous or rubbery state when at or above said reflow temperature. The reflow temperature may be a temperature at which the second value is a predetermined amount larger than said first value. Alternatively, the value representative of the state transition temperature may be an inverse of the state temperature or an inverse of the reflow temperature. In that case, the value representative of the state transition temperature may be a temperature at which the second value is a predetermined amount smaller than said first value.

The state transition temperature of the resist material depends on the inherent characteristics, such as intra- and intermolecular parameters. The state transition temperature also depends on the interfacial interaction of the resist material with the environment, e.g., with the underlayer material. For example, the glass transition temperature of polymers correlates with film thickness and interfacial interactions, which may be due to an altered mobility of the polymer chains at the interface (e.g., between the resist material and the underlayer material). As such, determining the value representative of the state transition temperature may provide information on potential changes in interfacial interactions, as these interactions will influence said value representative of the state transition temperature. Thus, a distinction may be made between the state transition temperature of the bulk resist material, and the state transition temperature of the resist structure formed of the resist material, which may - in particular for small structures such as the resist structures, for which the interfacial interactions may have a large effect on the state transition temperature - be substantially different from the state transition temperature of the bulk resist material. Some embodiments of the present invention are for providing the state transition temperature of the resist structure.

In some embodiments, for at least one of the plurality of entities, the temperature at which the heat treatment is applied is below a state transition temperature of a bulk volume of the resist material. In preferred embodiments, for at least another of the plurality of entities, the temperature at which the heat treatment is applied is above the state transition temperature of the bulk volume of the resist material. It is an advantage of these embodiments that the reflow temperature, representative of the state transition temperature, may be accurately determined. In preferred embodiments, the plurality of entities comprises at least 2 entities, such as at least 3 entities, such as at least 4 entities. It is an advantage of using more entities that the value representative of the state transition temperature may be accurately determined. However, to remain cost-efficient and labour-efficient, the number of entities is, preferably, not too large. Typically, the plurality of entities contains from 5 to 20 entities.

Preferably, the resist material is a chemically amplified resist. Indeed, this method is particularly suitable for determining the value for the state transition temperature, e.g., the glass transition temperature, of a chemically amplified resist, for which the value representative of the state transition temperature may be particularly easily observable due to reflow of protons, i.e., acid, present in the resist structures. The chemically amplified resist may comprise a polymer and protons that typically remain in the chemically amplified resist after their generation from a photoacid used during formation of the chemically amplified resist.

The resist structure may typically have, amongst the predetermined dimensions, a height, perpendicular to a top surface of the substrate, that is at most 500 nm, such as at most 200 nm, such as at most 100 nm. The method is particularly suitable for thin resist structures, for which interface effects have a relatively large effect on their properties. In embodiments, the resist structure may be a resist film or a resist line structure, preferably a resist line structure. The resist line structure typically has a rectangular cuboid shape. In embodiments, amongst the predetermined dimensions, the resist line structure may have a length that is larger than a width and larger than a height. Said width may be from 5 to 500 nm, such as from 10 to 200 nm. Said length may be at least 10 nm, such as at least 100 nm, such as at least 500 nm. A longer length may have the advantage that the correlation length of the line edge roughness or the line width roughness may be determined more accurately.

Step a) of the method of the first aspect may be performed on data earlier obtained. Thus, the method of the first aspect of the present invention may be performed on a computer, or by a person, without, e.g., requiring obtaining, processing comprising applying heat treatment, and analysing the plurality of entities for obtaining said data.

In some embodiments, the present invention also relates to the method in accordance with embodiments of the first aspect, wherein the method comprises, in step a), the following steps for obtaining said data:

a') obtaining the plurality of entities, wherein each entity comprises at least one resist structure, formed of the resist material and having said predetermined dimensions, on the underlayer material, wherein the measure representative of the spatial feature of the at least one resist structure has the first value before heat treatment,

a") applying the heat treatment to the plurality of entities, wherein a temperature at which the heat treatment is applied is different for each entity of the plurality of entities,

a''') determining the second value for said measure representative of the spatial feature after said heat treatment for the at least one resist structure of each of the plurality of entities, so as to obtain the correlation between the second value and the temperature at which the heat treatment is applied.

Said correlation obtained in step a''') then corresponds with the data represented by the data received in step a) of the method. The data may comprise, for each entity of the plurality of entities, the second value, and the corresponding temperature at which the heat treatment was applied. As such, the data set may represent a dependence of the second value on the temperature of the heat treatment.

In some embodiments wherein the resist structure is a chemically amplified resist, obtaining the plurality of entities in step a') comprises the steps of:

a'1) coating a plurality of substrates formed of the underlayer material with a coating formed of a precursor to the resist material, wherein said precursor to the resist material comprises:

a solvent,

a precursor polymer, dissolved in said solvent, that is capable of, on reaction with an acid, forming a polymer that is insoluble in said solvent, and

a photoacid that is capable of generating an acid on irradiation,

a'2) irradiating a region of the coating so as to induce the photoacid to generate said acid,

a'3) applying a heat treatment so as to induce a reaction of the precursor polymer with the acid, thereby transforming, in said region, the precursor polymer into the polymer that is insoluble in said solvent, and forming, in said region, the at least one resist structure, and

a'4) removing any unreacted precursor to the resist material from the substrate.

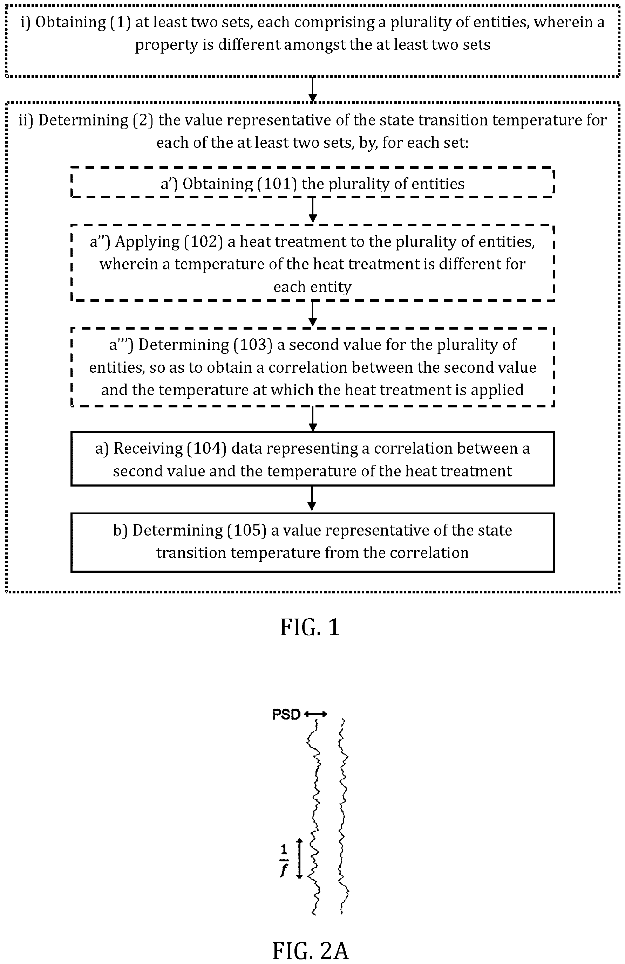

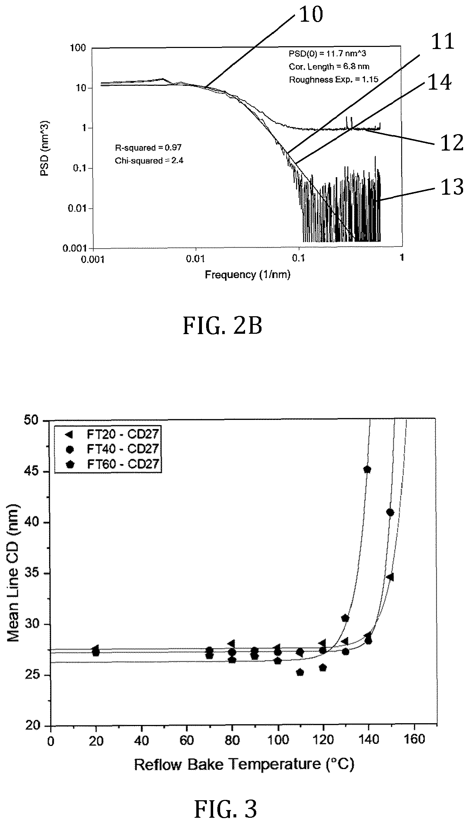

In some embodiments, in step a'''), a detection technique is used suitable for determining the second value for the measure representative of the spatial feature. Said detection technique may be an optical microscopy technique, although more typically, an electron microscopy technique is preferred due to the small dimensions of the resist structures. In embodiments, in step a'''), critical-dimension scanning electron microscopy is performed on a portion of each of the plurality of entities comprising said at least one resist structure. Critical-dimension scanning electron microscopy is particularly suitable for obtaining accurate information on spatial features, e.g., dimensions and/or roughness, of resist structures. In some embodiments, determining the second value comprises determining a power spectral density, e.g., an averaged power spectral density (i.e., the power spectral density averaged over a plurality of resist structures of each entity and/or averaged over different portions of each resist structure). The power spectral density may be obtained from an image, for example, obtained from optical microscopy or from scanning electron microscopy, preferably from said critical-dimension scanning electron microscopy. Herein, the power spectral density quantifies a variance in line edge roughness or line width roughness per unit frequency, wherein the frequency is a reciprocal of the length along the line edge. FIG. 2A (from C. Cutler et al., Roughness Power Spectral Density as a Function of Aerial Image and Basic Process / Resist Parameters, Journal of Photopolymer Science and Technology 32 (2019) pages 779-790) schematically depicts measurements of both edges of a resist structure, viewed from above. The power spectral density (PSD) may be the line edge roughness or the line width roughness, e.g., the variance of the line edge or the width, as a function of a length (1/frequency) along a longitudinal axis of the resist structure, i.e., said roughness or variance within a portion of the resist structure having said length. Reference is made to FIG. 2B, which is a schematic power spectral density as a function of the length. For high frequencies, i.e., small lengths, the variance is typically small - and decreases with shorter length -, as there is a correlation between different, nearby, points of the line edge along the longitudinal axis of the resist structure. For low frequencies, i.e., large lengths, different points of the line edge along the longitudinal axis of the resist structure are often uncorrelated to each other, so that the variance is large - and is typically constant for very long line length scales. The power spectral density provides a reliable way of determining the correlation length of the line edge or width roughness.

Mathematically, the power spectral density may be depicted as the Fourier transform of the autocorrelation function. The power spectral density is sometimes given by:

$$P\left(k_j\right) = \frac{1}{N^2}\left|F\left(k_j\right)\right|^2 \qquad \text{(eq. 4)}$$

with $F(k_j)$ a Fourier Transform of the edge:

$$F\left(k_j\right) = \sum_{m=1}^N y_m\, e^{2\pi jm/N} \qquad \text{(eq. 5)}$$

wherein $y_m = y(x_m)$ may be representative of the deviation of the width or edge of the resist structure from a straight line at a position $x_m$ along the resist structure, determined at N positions along the resist structure. (See, e.g., V. Constantoudis et al., Line edge roughness and critical dimension variation: Fractal characterization and comparison using model functions, Journal of Vacuum Science & Technology B: Microelectronics and Nanometer Structures 22 (2004) pages 1974-1981, and C. Cutler et al., Roughness Power Spectral Density as a Function of Aerial Image and Basic Process / Resist Parameters, Journal of Photopolymer Science and Technology 32 (2019) pages 779-790.)

In some embodiments, step a') further comprises forming a reference entity, comprising at least one reference resist structure, formed of the resist material and having said predetermined dimensions, on a reference substrate, e.g.., the underlayer material, and step a''') comprises selecting a portion of the reference entity that comprises the at least one reference resist structure having said predetermined dimensions, and wherein the second value for the at least one resist structure of each of the plurality of entities is determined on a corresponding portion, corresponding to said selected portion of the reference entity, of the each of the plurality of entities. The reference entity is typically not heat treated, so that, in step a'') when the second value is determined, the measure of the spatial feature still has the first value, whereas the measure may be different from the first value for the plurality of entities. As such, the first value may be accurately determined from the reference entity, during the same run when the second value may be determined for the plurality of entities. Furthermore, the reference entity and the plurality of entities may be formed using the technique, e.g., the same mask, so that for the corresponding portions, the measure for different entities typically would have had the first value before heat treatment. Therefore, in this way, the influence of the heat treatment on the measure may be accurately determined.

Any features of any embodiment may be independently as correspondingly described for any embodiment of any of the other aspects of the present invention.

In a second aspect, the present invention relates to a further method for determining a dependency of a value representative of a state transition temperature of a resist structure on an underlayer material, on a property of the resist structure or of the underlayer material. The further method comprises obtaining the value representative of the state transition temperature for each of at least two sets of entities, by performing the method according to embodiments of the first aspect or the second aspect of the present invention on each of the two sets of entities. Herein, each set comprises a plurality of entities, wherein, within each set of entities, each entity comprises at least one resist structure formed of a resist material and has predetermined dimensions, on the underlayer material, wherein, amongst different sets of entities, said property is different. It is an advantage of embodiments of the present invention that the value for the state transition temperature may be used for deriving properties of the entity, which in turn may be used for setting up and monitoring a lithography process.

In some embodiments, said property is one of a dimensional characteristic of the resist structure, a composition of the resist structure, or the underlayer material. Said dimensional characteristic is preferably a width or a height of the resist structure. Said composition of the resist structure may be a material, e.g., a type of polymer, or a concentration, e.g., a concentration of protons, comprised in the resist structure. The property that is varied between the sets of entities typically influences interactions between the resist structure and the underlayer material. Thereby, a difference in said property between the sets of entities may result in a change in state transition temperature, or a value representative thereof, between the sets of entities. Typically, only said property is varied between the sets, while other features (e.g., the dimensional characteristic of the resist structure, the composition of the resist structure, and/or the underlayer material) are the same between the different sets. This may enable straight-forward determination of a dependency of the value representative of the state transition temperature on the property.

In some embodiments, the dimensional characteristic is representative of a product of a volume of the resist structure and a ratio of an exposed area of the resist structure to an interface area of the resist structure with the underlayer material. The inventors have observed that the relatively large influence of the interface on the properties of the resist structure may result in difficult to interpret dependencies on said property. Said dependency may be more accurately determined after normalization for said product of said volume and said ratio.

In some embodiments, obtaining the value representative of the state transition temperature for each of at least two sets of entities, by performing the method according to embodiments of the first aspect or second aspect of the present invention on each of the two sets of entities, comprises: i) obtaining at least two sets of entities, each set comprising a plurality of entities, wherein, within each set of entities, each entity comprises at least one resist structure formed of a resist material and having predetermined dimensions, on a substrate, i.e., underlayer material, wherein, amongst different sets of entities, said property is different, and ii) determining the value representative of the state transition temperature for each of the at least two sets of entities, by performing the method according to embodiments of the first aspect or second aspect of the present invention on each of the two sets of entities.

Any features of any embodiment of the second aspect may be independently as correspondingly described for any embodiment of any of the other aspects of the present invention.

In a third aspect, the present invention relates to a data processing apparatus comprising means configured for carrying out embodiments of the method according to embodiments of the first aspect of the present invention, and/or embodiments of the further method in accordance with embodiments of the second aspect of the present invention, in as far as obtaining the value representative of the state transition temperature for each of the at least two sets of entities comprises carrying out the method according to embodiments of the first aspect of the present invention.

Said data processing apparatus may further comprise means configured for inducing a device to carry out embodiments of steps relating to obtaining, processing applying heat treatment, and analysing the plurality of entities, e.g., the steps a'), a") and a‴), of the method of embodiments of the second aspect of the present invention. For example, the data processing apparatus may comprise instructions that may be provided to said device so as to induce the device to carry out embodiments of the steps a'), a") and a‴).

Any features of any embodiment of the third aspect may be independently as correspondingly described for any embodiment of any of the other aspects of the present invention.

In a fourth aspect of the present invention, the present invention relates to a computer program comprising instructions which, when the program is executed by a computer, cause the computer to carry out embodiments of the first aspect of the present invention, or embodiments of the further method in accordance with embodiments of the third aspect of the present invention, in as far as obtaining the value representative of the state transition temperature for each of the at least two sets of entities comprises carrying out embodiments of the first aspect of the present invention.

Said computer program may further comprise instructions configured for inducing a device to carry out embodiments of steps relating to obtaining, processing applying heat treatment, and analysing the plurality of entities, e.g., the steps a'), a") and a‴), of the method of embodiments of the second aspect of the present invention. For example, the data processing apparatus may comprise instructions that may be provided to said device so as to induce the device to carry out embodiments of the steps a'), a") and a‴).

Any features of any embodiment of the fifth aspect may be independently as correspondingly described for any embodiment of any of the other aspects of the present invention.

In a fifth aspect, the present invention relates to a computer-readable medium having stored thereon the computer program of embodiments of the fourth aspect of the present invention.

Any features of any embodiment of the sixth aspect may be independently as correspondingly described for any embodiment of any of the other aspects of the present invention.

In a sixth aspect, the present invention relates to a device comprising means for applying a heat treatment to a plurality of entities, wherein each entity comprises at least one resist structure, formed of a resist material and having predetermined dimensions, on a substrate, i.e., underlayer material, wherein a measure representative of a spatial feature of the at least one resist structure has a first value before heat treatment, wherein a temperature at which the heat treatment is applied is different for each entity of the plurality of entities. The device further comprises means for determining a second value for said measure representative of the spatial feature after said heat treatment for the at least one resist structure of each of the plurality of entities, so as to obtain a correlation between the second value and the temperature at which the heat treatment is applied. The device further comprises means for determining, from said correlation, a value representative of a state transition temperature, for which, when the heat treatment would be performed at such temperature, said second value differs by a predetermined amount from said first value.

In some embodiments, the means for applying said heat treatment comprises an oven.

The means for determining the second value may comprise any suitable means for obtaining said second value, and may depend on the spatial feature and/or the measure. For example, the means for determining the second value may comprise a scanning electron microscope or an optical detector, e.g., an optical microscope. Preferably, said means comprises a critical dimension scanning electron microscope.

In some embodiments, the means for determining, from said correlation, a value representative of a state transition temperature may comprise a data processing apparatus in accordance with embodiments of the fourth aspect of the present invention, a computer program in accordance with embodiments of the fourth aspect of the present invention, or a computer-readable medium in accordance with embodiments of the sixth aspect of the present invention.

Any features of any embodiment of the sixth aspect may be independently as correspondingly described for any embodiment of any of the other aspects of the present invention.

Particular and preferred aspects of the invention are set out in the accompanying independent and dependent claims. Features from the dependent claims may be combined with features of the independent claims and with features of other dependent claims as appropriate and not merely as explicitly set out in the claims.

Although there has been constant improvement, change and evolution of devices in this field, the present concepts are believed to represent substantial new and novel improvements, including departures from prior practices, resulting in the provision of more efficient, stable and reliable devices of this nature.

The above and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

FIG. 1 is a flow chart of a method in accordance with embodiments of the present invention.

FIG. 2A is a schematic plot of measurements of the edges of a resist line structure.

FIG. 2B is a plot of an exemplary power spectral density as a function of frequency.

FIG. 3 is a graph showing a correlation between a second value for a mean line CD and the temperature used for the heat treatment, for three sets of entities comprising resist structures having a predetermined width of 27 nm.

FIG. 4 is a graph showing a correlation between a second value for a mean line CD and the temperature used for the heat treatment, for three sets of entities comprising resist structures having a predetermined width of 40 nm.

FIG. 5 is a graph showing a correlation between a second value for an LWR correlation length and the temperature used for the heat treatment, for three sets of entities comprising resist structures having a predetermined width of 27 nm.

FIG. 6 is a graph showing a correlation between a second value for an LWR correlation length and the temperature used for the heat treatment, for three sets of entities comprising resist structures having a predetermined width of 40 nm.

FIG. 7 is a graph showing a correlation between a second value for a mean line CD and the temperature used for the heat treatment, for four sets of entities comprising resist structures having a predetermined height of 40 nm.

FIG. 8 is a graph showing a correlation between a second value for an LWR correlation length and the temperature used for the heat treatment, for four sets of entities comprising resist structures having a predetermined height of 40 nm.

FIG. 9 is a graph showing a correlation between a second value for an LWR correlation length and the temperature used for the heat treatment, wherein dashed lines indicate how a value representative of the glass transition temperature may be derived from said correlation.

FIG. 10 is a graph showing a dependency of a value representative of the glass transition temperature as dependent on a property that is the mean line CD, for resist structures having a predetermined height of 40 nm.

FIG. 11 is a graph showing a dependency of a value representative of the glass transition temperature as dependent on a property that is the resist film thickness, for six different sets of entities.

FIG. 12 is a graph showing a dependency of a value representative of the glass transition temperature as dependent on a property that is the inverse of the volume factor, for eight different sets of entities.

FIG. 13A is a schematic representation of an entity comprising three resist structures having a height of 60 nm and a width and half-pitch of 27 nm.

FIG. 13B is a schematic representation of an entity comprising two resist structures having a height of 40 nm and a width and half-pitch of 40 nm.

FIG. 14 is a graph showing a dependency of a value representative of the glass transition temperature as dependent on a property that is the inverse of the product of the volume factor and the area factor, for eight different sets of entities.

FIG. 15 is a graph showing a dependency of a value representative of the glass transition temperature as dependent on a property that is the product of the volume factor and the area factor, for eight different sets of entities.

In the different figures, the same reference signs refer to the same or analogous elements.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not correspond to actual reductions to practice of the invention.

Furthermore, the terms first, second, third and the like in the description and in the claims, are used for distinguishing between similar elements and not necessarily for describing a sequence, either temporally, spatially, in ranking or in any other manner. It is to be understood that the terms so used are interchangeable under appropriate circumstances and that the embodiments of the invention described herein are capable of operation in other sequences than described or illustrated herein.

Moreover, the terms top, bottom, over, under and the like in the description and the claims are used for descriptive purposes and not necessarily for describing relative positions. It is to be understood that the terms so used are interchangeable under appropriate circumstances and that the embodiments of the invention described herein are capable of operation in other orientations than described or illustrated herein.

It is to be noticed that the term "comprising", used in the claims, should not be interpreted as being restricted to the means listed thereafter; it does not exclude other elements or steps. It is thus to be interpreted as specifying the presence of the stated features, integers, steps or components as referred to, but does not preclude the presence or addition of one or more other features, integers, steps or components, or groups thereof. The term "comprising" therefore covers the situation where only the stated features are present and the situation where these features and one or more other features are present. The word "comprising" according to the invention therefore also includes as one embodiment that no further components are present. Thus, the scope of the expression "a device comprising means A and B" should not be interpreted as being limited to devices consisting only of components A and B. It means that with respect to the present invention, the only relevant components of the device are A and B.

Reference throughout this specification to "one embodiment" or "an embodiment" means that a particular feature, structure or characteristic described in connection with the embodiment is included in at least one embodiment of the present invention. Thus, appearances of the phrases "in one embodiment" or "in an embodiment" in various places throughout this specification are not necessarily all referring to the same embodiment, but may. Furthermore, the particular features, structures or characteristics may be combined in any suitable manner, as would be apparent to one of ordinary skill in the art from this disclosure, in one or more embodiments.

Similarly it should be appreciated that in the description of exemplary embodiments of the invention, various features of the invention are sometimes grouped together in a single embodiment, figure, or description thereof for the purpose of streamlining the disclosure and aiding in the understanding of one or more of the various inventive aspects. This method of disclosure, however, is not to be interpreted as reflecting an intention that the claimed invention requires more features than are expressly recited in each claim. Rather, as the following claims reflect, inventive aspects lie in less than all features of a single foregoing disclosed embodiment. Thus, the claims following the detailed description are hereby expressly incorporated into this detailed description, with each claim standing on its own as a separate embodiment of this invention.

Furthermore, while some embodiments described herein include some but not other features included in other embodiments, combinations of features of different embodiments are meant to be within the scope of the invention, and form different embodiments, as would be understood by those in the art. For example, in the following claims, any of the claimed embodiments can be used in any combination.

Furthermore, some of the embodiments are described herein as a method or combination of elements of a method that can be implemented by a processor of a computer system or by other means of carrying out the function. Thus, a processor with the necessary instructions for carrying out such a method or element of a method forms a means for carrying out the method or element of a method. Furthermore, an element described herein of an apparatus embodiment is an example of a means for carrying out the function performed by the element for the purpose of carrying out the invention.

In the description provided herein, numerous specific details are set forth. However, it is understood that embodiments of the invention may be practiced without these specific details. In other instances, well-known methods, structures and techniques have not been shown in detail in order not to obscure an understanding of this description.

Reference is made to FIG. 1, which is a flow chart of a method in accordance with embodiments of the present invention.

In a first aspect, the present invention relates to a method for determining a value representative of a state transition temperature of a resist structure, formed of a resist material and having predetermined dimensions, on an underlayer material. The method comprises:

a) receiving 104 data representing a correlation between a second value for a measure representative of a spatial feature of at least one resist structure of each of a plurality of entities after applying a heat treatment, and a temperature at which said heat treatment is applied,
each entity comprising the at least one resist structure, formed of the resist material and having said predetermined dimensions before said heat treatment, on the underlayer material, and wherein said measure has a first value before said heat treatment, and

b) determining 105, from said correlation, said value representative of the state transition temperature, for which, when the heat treatment would be performed at such temperature, said second value differs by a predetermined amount from said first value.

In some embodiments, obtaining data may be receiving such data, e.g. via a data input port, whereby such data may be obtained earlier, or it may be obtaining such data by measuring it at that moment in time or earlier.

The method may further comprise, as part of step a), the following steps for obtaining said data:

a') obtaining 101 the plurality of entities, wherein each entity comprises at least one resist structure, formed of the resist material and having said predetermined dimensions, on the underlayer material, wherein the measure representative of the spatial feature of the at least one resist structure has the first value before heat treatment,

a") applying 102 the heat treatment to the plurality of entities, wherein a temperature at which the heat treatment is applied is different for each entity of the plurality of entities,

a''') determining 103 the second value for said measure representative of the spatial feature after said heat treatment for the at least one resist structure of each of the plurality of entities, so as to obtain the correlation between the second value and the temperature at which the heat treatment is applied.

In a second aspect, the present invention relates to a further method for determining a dependency of a value representative of a state transition temperature of a resist structure on an underlayer material, on a property of the resist structure or of the underlayer material. The further method comprises obtaining the value representative of the state transition temperature for each of at least two sets of entities, by performing the method according to embodiments of the first aspect of the present invention on each of the two sets of entities. Herein, each set comprises a plurality of entities, wherein, within each set of entities, each entity comprises at least one resist structure formed of a resist material and having predetermined dimensions, on a substrate, wherein, amongst different sets of entities, said property is different. It is an advantage of embodiments of the present invention that the value for the state transition temperature may be used for deriving properties of the entity, which in turn may be used for setting up and monitoring a lithography process.

In FIG. 1, steps in full-lined boxes, i.e., steps a) and b) in accordance with embodiments of the first aspect of the present invention, are considered essential steps. Steps in dashed boxes, i.e., steps a'), a") and a''') in accordance with specific embodiments of the present invention, are considered optional steps. Dotted boxes represent steps that may be performed in embodiments of the third aspect of the present invention, wherein, for example, obtaining the value representative of the state transition temperature for each of at least two sets of entities, by performing the method according to embodiments of the first aspect or second aspect of the present invention on each of the two sets of entities, comprises: i) obtaining 1 at least two sets of entities, each set comprising a plurality of entities, wherein, within each set of entities, each entity comprises at least one resist structure formed of a resist material and having predetermined dimensions, on a substrate, wherein, amongst different sets of entities, said property is different, and ii) determining 2 the value representative of the state transition temperature for each of the at least two sets of entities, by performing the method according to embodiments of the first aspect or second aspect of the present invention on each of the two sets of entities.

The invention will now be described by a detailed description of several embodiments of the invention. It is clear that other embodiments of the invention can be configured according to the knowledge of persons skilled in the art without departing from the technical teaching of the invention, the invention being limited only by the terms of the appended claims.

Example: obtaining a plurality of entities and applying a heat treatment

An underlayer material, which is, in this example, an organic underlayer, having a thickness of 20 nm, was spin coated on top of a plurality of silicon wafer. The organic underlayer was subsequently baked at 205°C for 60 seconds, as recommended by the vendor of the organic underlayer. On top of this underlayer, different coatings formed of a precursor to the resist material, that is an extreme-ultraviolet (EUV) chemically amplified resists (CAR), were manually spin coated. Coatings were formed having a nominal resist film thickness (FT) of 10, 20, 40 and 60 nm. Subsequently, the coatings were baked at 90°C for 60 seconds, as recommended by the vendor of the CAR material. The film thickness of the coatings was checked using ellipsometry, and the nominal resist FT values were confirmed.

The different coatings formed of the precursor to the resist material were subsequently exposed in an ASML full-field NXE:3400 scanner with a custom X-dipole illumination in a focus-exposure matrix (FEM) to print 1:1 resist structures and spaces, that is, wherein the width of the resist structures is equal to the distance between adjacent resist structures. Subsequently, the coatings received a post-exposure bake of 90°C for 60 seconds. Next, the coatings were developed with a 2.38% tetramethyl-ammonium hydroxide (TMAH) solution, thereby obtaining different sets of entities, each set comprising a plurality of entities.

Eight sets of entities were formed in this way: for each set, the predetermined dimensions of the resist structures are summarized in Table 1.

For each set of entities, each entity was baked, i.e., heat treated, after said exposure, at a different temperature. Said heat treatment may initiate a reflow process when the heat treatment is performed at a temperature that is above a glass temperature. For each set, a reference entity, having otherwise the same features as other entities of the set, did not receive a heat treatment.

From this heat treatment, subsequently, a reflow temperature may be determined that is proportional to the glass temperature of the resist structure.

Example: CDSEM and Power Spectral Density (PSD)

Patterning images were taken with a Hitachi CG-6300 critical dimension scanning electron microscope (CDSEM). For each set of entities for which the resist structures have a particular height, i.e., resist FT, the reference entity was used to determine a die on the entity having the best dose and best focus condition for a specific width and half-pitch of the resist structures. As each entity within a set was prepared in the same way, except for the heat treatment after the exposure, it may be assumed that the resist structures within corresponding dies (i.e., dies at the same corresponding location for each wafer) for the different entities had the same spatial features before said heat treatment, so that only the heat treatment may have induced any differences between the resist structures.

For each entity of each set, and for each reference entity for each set, the selected die was investigated by taking 50 images at different locations within the die. For the CDSEM images, the following settings were used: 1638 nm x 1638 nm images at 2048 x 2048 pixels, 83K magnification, 0.8 nm pixel size, for a total area of 128 $\mu m^2$. These images were subsequently analyzed with Fractilia MetroLER software versions 2.2.0 to obtain the critical dimension, i.e., the width, the unbiased line-width roughness (LWR), and the corresponding power spectral density (PSD), in this example, the line-width roughness per unit length.

Reference is made to FIG. 2B, which is a plot of an exemplary power spectral density as a function of frequency. Herein, line 12 is the measured, biased PSD. An important aspect of the PSD is that it enables the quantification of the scanning electron microscopy noise floor (which is the plateau at high frequencies) from the biased PSD to obtain the unbiased PSD, i.e., line 13. Moreover, it provides additional information on the size-scale distribution of the roughness. The PSD plot also allows for determining some parameters that are easily comparable: the (e.g., unbiased) line edge roughness (LER) and/or line width roughness (LWR), which correlates with the integral of the curve; the characteristic correlation length 10 for the resist, which is a frequency at which the PSD curve starts to fall-off at a predetermined rate, e.g., has a predetermined negative slope, or is a predetermined amount below the PSD at low frequencies; a roughness exponent (H), that is derived from the slope 11 of the PSD at frequencies substantially larger than the frequency at the correlation length 10 by:

$$slope = 2 \times H + 1 \qquad\qquad (eq.\ 6)$$

and the extrapolated PSD(0) value, which gives an idea of the uncorrelated roughness that can be obtained. For example, the unbiased PSD line 13, plotted in FIG. 2B, may be fitted (line 14) using the following equation:

$$PSD\ (f) = PSD(0)\ /\ (1 + (2\ \pi\ f\ \xi)^{2 \times H + 1}) \qquad\qquad (eq.\ 7)$$

with f the frequency, $\xi$ the correlation length and H the roughness exponent.

Example: Determine a dependency of a value representative of a glass transition temperature on a property of a resist structure

In this example, the effect of different heights for the resist structures (commonly called the resist film thicknesses) at fixed widths for the resist structures (commonly called the critical dimension values) as well as the effect of a fixed height at different widths, on the value representative of the glass temperature, was determined.

Table 1 provides an overview of the eight different sets of entities that were prepared, with, for each set, a different combination of predetermined dimensions for the resist structures, comprising the height, the width, and the predetermined half-pitch, which is equal to the width.

Table 1. Overview of the predetermined dimensions (height, width, and half-pitch) of the resist structures for different sets of entities prepared for this example.

| Height (nm) | Width (nm) | Half-pitch (nm) |
|---|---|---|
| 20 | 27 | 27 |
| 20 | 40 | 40 |
| 40 | 27 | 27 |
| 40 | 40 | 40 |
| 40 | 55 | 55 |
| 40 | 110 | 110 |
| 60 | 27 | 27 |
| 60 | 40 | 40 |

First, the effect of the height on the value representative of the glass temperature was determined. For this, a second value for a measure representative of a spatial feature was determined for different sets of a plurality of entities, each set having a different combination of predetermined (i.e., before the heat treatment) resist film thicknesses, namely 20, 40 and 60 nm, and predetermined critical dimensions and corresponding predetermined half-pitches, namely 27 nm and 40 nm. The measure representative of the spatial feature is, in this example, the mean critical dimension of the resist structures (mean line CD), as measured using CDSEM, and which is representative of the mean width of the resist structures.

Reference is made to FIG. 3, which is a graph of a second value for the mean line CD, as a function of the temperature used for the heat treatment, i.e., the "Reflow Bake Temperature", for three different sets of entities, wherein the predetermined width, i.e., critical dimension, is 27 nm (i.e., as indicated in the legend by "CD27"). Experimental data points, and an exponential function fitted to the experimental data points (curves; see also below) are shown: herein, triangles represent the set of entities for which the predetermined film thickness is 20 nm (i.e., as indicated in the legend by "FT20"); dots represent the set of entities for which the predetermined film thickness is 40 nm (i.e., as indicated in the legend by "FT40"); and pentagons represent the set of entities for which the predetermined film thickness is 60 nm (i.e., as indicated in the legend by "FT60").

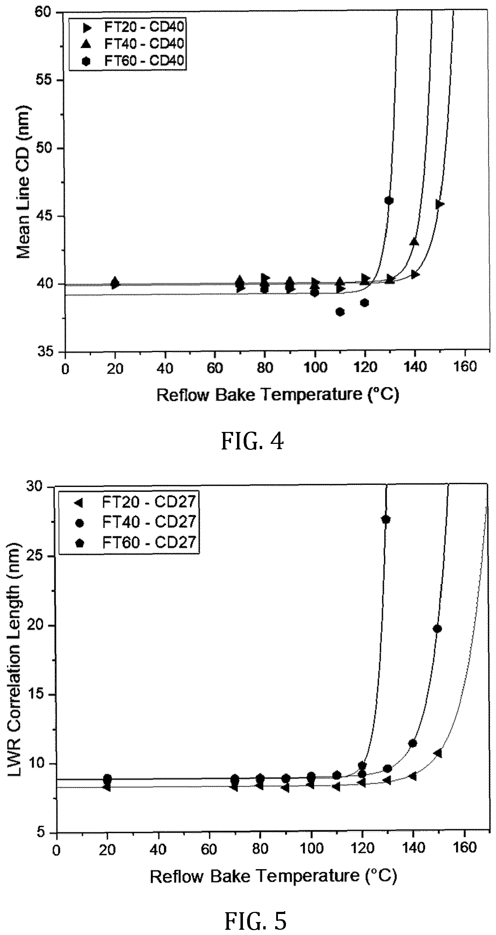

Simultaneously, reference is made to FIG. 4, which is a graph of a second value for the mean line CD, as a function of the temperature used for the heat treatment, for three different sets of entities, wherein the predetermined width is 40 nm. Experimental data points, and an exponential function fitted to the experimental data points (curves; see also below) are shown: herein, as indicated by the legend, right-pointing triangles represent the set of entities for which the predetermined film thickness is 20 nm; dots represent the set of entities for which the predetermined film thickness is 40 nm; and hexagons represent the set of entities for which the predetermined film thickness is 60 nm.

For both FIG. 3 and FIG. 4, each datapoint represents the averaged results of 50 SEM images within a selected die. In FIG. 3 and FIG. 4, within each set, each datapoint represents a different entity at the same dose and focus condition, but the temperature of the heat treatment applied to the entity is different. The figure shows that, for each set, the second value for the mean line CD remains constant under different reflow bake temperatures, i.e., different temperatures for the heat treatment, up until a certain temperature where the CD starts to increase, which is the temperature at which material in the resist structures has started to reflow during the heat treatment.

From FIG. 3 and FIG. 4, it may be qualitatively observed that the onset of the reflow starts at lower temperatures for larger predetermined heights, and higher temperatures for smaller predetermined heights of the resist structures.

When looking in more detail, it may be observed that the experimental data points for the sets for which the predetermined height of the resist structures is 60 nm, exhibit an apparent dip in the second value for the mean line CD. This dip occurs at temperatures just below the temperature at which the resist material start to reflow, e.g., just below the value representative of the glass transition temperature, namely in the range of from approximately 100 to 120 °C. This decrease may indicate a partial thermal decomposition of the resist material, i.e., of the organic material of the resist structures, or evaporation of any liquid, e.g. developer or rinse liquid, remaining in the resist structures. At temperatures above 120 °C, a drastic increase of the second value may be observe, indicating the onset of the reflow process.

For each set of entities, a first value may be derived that is, for example, the mean line CD at 20°C (i.e., wherein no heat treatment is performed), derived from the fit, or, alternatively, the first value determined for the reference entity that was not heat treated. The value representative of the glass transition temperature may then be assumed to be the temperature at which the mean line CD is a predetermined amount larger than the first value, e.g., a predetermined percentage, e.g., 10% higher, or a predetermined number, e.g., 2 nm, higher.

Since it was observed that using the mean line CD as measure for determining the value representative of the glass transition temperature may not be stable when the predetermined height of the resist structures is 60 nm or higher, a more robust measure may be preferred. The inventors have found that a useful measure, that may be readily extracted from the power spectral density plot, is the correlation length of the line width roughness. Without being bound by theory, the usefulness of this parameter may be understood as the reflow of resist material above a value representative of the glass transition temperature, e.g., above the glass transition temperature, may result in a reshape or rearrangement of the resist structure under influence of temperature. Consequently, also the length scale over which the roughness is correlated may change with it.

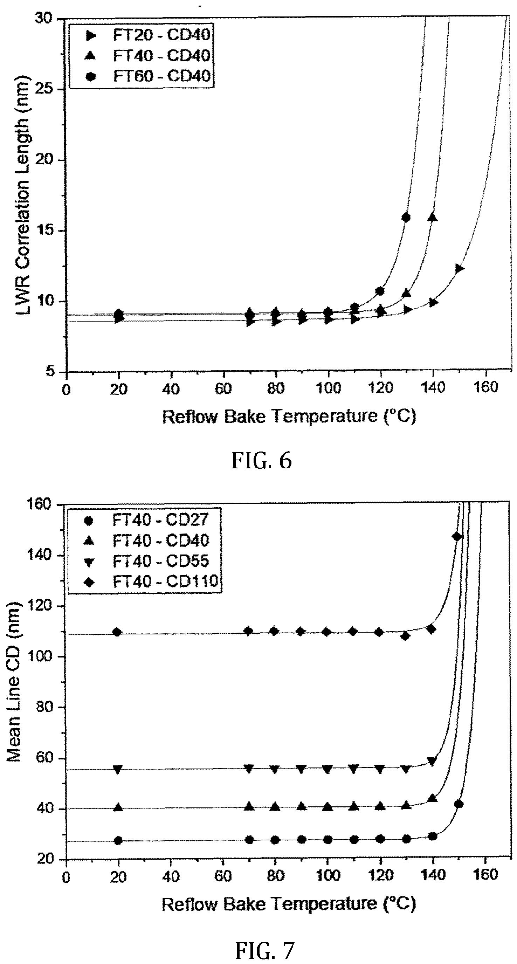

Reference is made to FIG. 5 and FIG. 6, which are plots relating to the same sets of entities as for FIG. 3 and FIG. 4, respectively, but the measure representative of the spatial feature is now the correlation length of the line width roughness. FIG. 5 and FIG. 6 qualitatively confirm that the temperature at which reflow of resist material happens reduces with increasing height of the resist structures. In other words, it appears that from both measures (i.e., mean line CD and LWR correlation length), the value representative of the glass transition temperature decreases with increasing height of the resist structures.

In FIG. 5 and FIG. 6, no dip, i.e., reduction in the second value, for the LWR correlation length is observed, which may indicate that there is no thermal degradation or evaporation of any remaining liquid in the resist structures, for sets for which the predetermined height of the resist structures is 60 nm. Thus, it appears that the line width roughness correlation length is preserved in the sense that it is not influenced by said decomposition or evaporation. Therefore, while the behaviour of both the mean line CD and LWR correlation length versus temperature of the heat treatment is, in general, similar, the absence of the dip for the LWR correlation length may make fitting of the curves to obtain a reflow temperature more robust and accurate.

Also the influence of the width on the value representative of the glass transition temperature, for a fixed resist film thickness, was investigated. For this, four sets of entities, each set having resist structures having a different predetermined width and half-pitch, were obtained, namely a width and half-pitch of 27, 40, 55 and 110 nm, and a predetermined height that is 40 nm for each of the four sets.

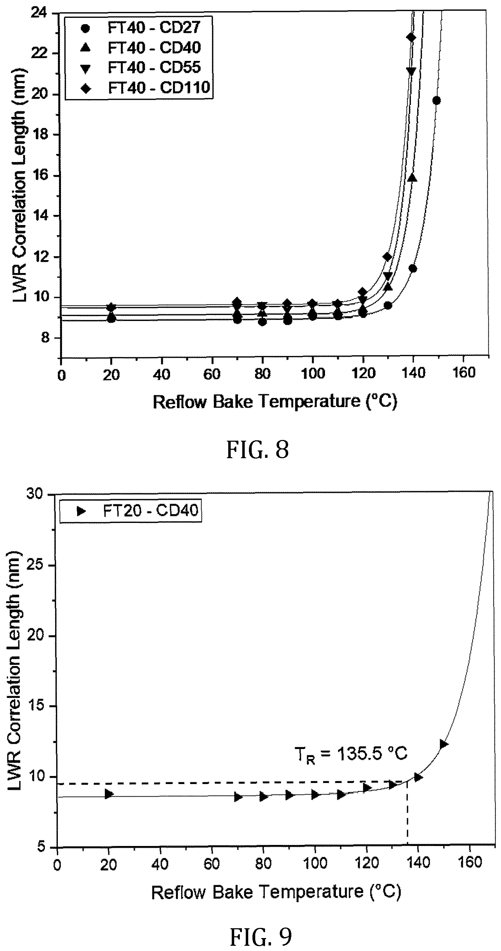

Reference is made to FIG. 7, which shows the second value for the mean line CD as dependent on temperature of the heat treatment for each of the four sets of entities. Simultaneously, reference is made to FIG. 8, which shows the second value for the LWR correlation length as dependent on temperature of the heat treatment for each of the four sets of entities. A qualitative observation that can be made is that for a fixed height, the onset temperature for the reflow of resist material is lower for resist structures having larger widths (55 and 110 nm) than for resist structures having smaller widths (27 and 40 nm).

Above, it was qualitatively confirmed that both height and width are properties of the resist structure that influence the onset of the reflow process, i.e., the value representative of the glass transition temperature. In a next step, we obtain an exact corresponding value representative of the glass temperature, which may, in this example, also be called a reflow temperature $T_R$. In this example, we proceed with the LWR correlation length versus reflow bake temperature. These experimental data appear to exhibit an exponential behaviour and are thus (as already mentioned above) fitted with an exponential function:

$$y(x) = A_1 \cdot e^{x/t_1} + y_0 \qquad\qquad \text{(eq. 3)}$$

This fit with the exponential function is plotted for each set of data points in each of FIG. 3-8. For the data points that represent the LWR correlation length as dependent on the heat treatment temperature, an $R^2 > 0.99$ was obtained. As may be observed, due to the dip, for the fit to the data points that represent the mean line CD as dependent on the heat treatment temperature, a less optimal fit was obtained.

The reflow temperature $T_R$ may now be extracted from the curves, fitted to the LWR correlation length as dependent on the temperature of the heat treatment, in several ways. For example, an asymptotic value of the temperature of the heat treatment, in the infinite limit of LWR correlation length, could be used. More preferably, however, the reflow temperature $T_R$ may be assumed to be at the point where the LWR correlation length starts to increase. After all, it is at this point that the reflow process begins. We have arbitrarily chosen to determine the reflow temperature $T_R$ to be at the temperature where the second value for the LWR correlation length, i.e., $y(x)$, reaches a 10% higher value compared to the yo-value, i.e., the first value. In other words, in this example, at the reflow temperature, the second value for the LWR correlation length is 10% higher than the first value for the LWR correlation length. An advantage of this choice is that the thus determined reflow temperature $T_R$ is located within the range of measured data points, and not in an extrapolated region, which may make the value more reliable. Although, in principle, any predetermined amount (e.g., different from 10%) could be used to extract the reflow temperature $T_R$, as long as the same predetermined amount is used for the different sets, the $T_R$ values of the different sets may be expected to show a trend relative to one another.

Reference is made to FIG. 9, which is a plot of the LRW correlation length for the set of entities with a predetermined width of 40 nm and a predetermined resist height of 20 nm. The horizontal dashed line corresponds to an increase of 10% with respect to the fitted LWR correlation length at low temperatures ($y_0$-value); the reflow temperature $T_R$ is at the intersect of the horizontal dashed line with the fitted curve. As may be observed, in FIG. 9, the reflow temperature is derived to be 135.5 °C.

Example: Reflow temperature for probing interfacial interactions

Now follows a quantitative analysis and explanation on the parameters that influence the value for the reflow temperature, i.e., the value representative of the glass transition temperature, to show that the method of embodiments of the present invention may be used for investigating changes in interfacial interactions. The above explained fitting and extraction of the reflow temperature $T_R$ was performed for each of the sets of entities summarized in Table 1.

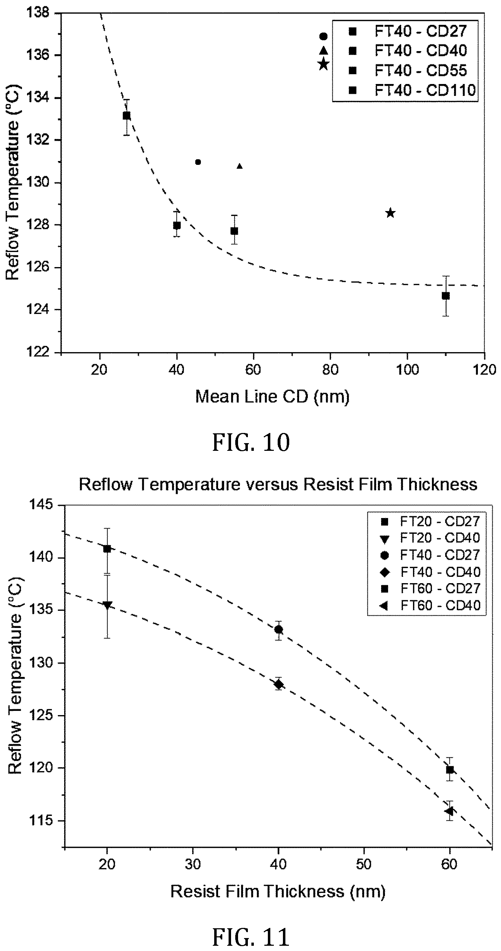

Reference is made to FIG. 10, which is a plot of the extracted reflow temperature $T_R$ as function of a predetermined width (i.e., CD) and a constant predetermined height (i.e., FT) of 40 nm. As may be observed, this plot confirms quantitatively that a smaller width for the resist structures is associated with a higher $T_R$. When the width increases, for constant height, both the volume of the resist structure and the contact area between the resist structure and the underlayer material, increase. This results in an exponential effect of the mean line CD on the $T_R$.

For larger mean line CD (40, 55, 110 nm), the $T_R$ remains largely unaffected by the increased volume and resist-underlayer interaction surface and shows a relatively small reduction in $T_R$ with increasing mean line CD. However, the $T_R$ seems extremely sensitive when decreasing the mean line CD past a threshold value, which results in a rapid increase of $T_R$ for decreasing mean line CD beyond this threshold value. This indicates that the volume plays a dominant role compared to the resist-underlayer interaction surface when determining the $T_R$.

Reference is made to FIG. 11, which is a plot of the reflow temperature $T_R$ as dependent on predetermined height, i.e., Resist Film Thickness, for two different, fixed widths of 27 nm and 40 nm. As is quantitatively confirmed, a thicker predetermined Resist Film Thickness indeed results in a lower $T_R$. By increasing the Resist Film Thickness and keeping the width constant, the volume of the resist structure is scaled without changing the resist-underlayer interaction surface. This figure also nicely shows our earlier confirmed trend, that a larger width may result in a lower $T_R$ value. The difference in $T_R$ between the widths of 27 nm and 40 nm become smaller as the height, i.e., Resist Film Thickness, increases, indicating that volume plays a large role in affecting the $T_R$.

We have now quantitatively confirmed that the $T_R$ scales with the inverse of the width and the height. To confirm the reflow methodology as a potential way to investigate interfacial interactions, it is now useful to perform a more in-depth analysis and attempt to unify both width and height variation for the different data sets in a single master plot that shows and confirms the dependencies of $T_R$.

The volume of a resist structure may be assumed to be the width, i.e., CD, multiplied by the height, i.e., resist film thickness FT, and the length of the resist structure. However, as, in this example, the length of the resist structure is a constant for all data points, the product of the width and the height may be assumed as a volume (scaling) factor (VF):

$$\text{Resist volume} = \text{width} \times \text{height} \times \text{length} \qquad (\text{eq. 8})$$

$$\text{Volume Factor} = \text{width} \times \text{height} \qquad (\text{eq. 9})$$

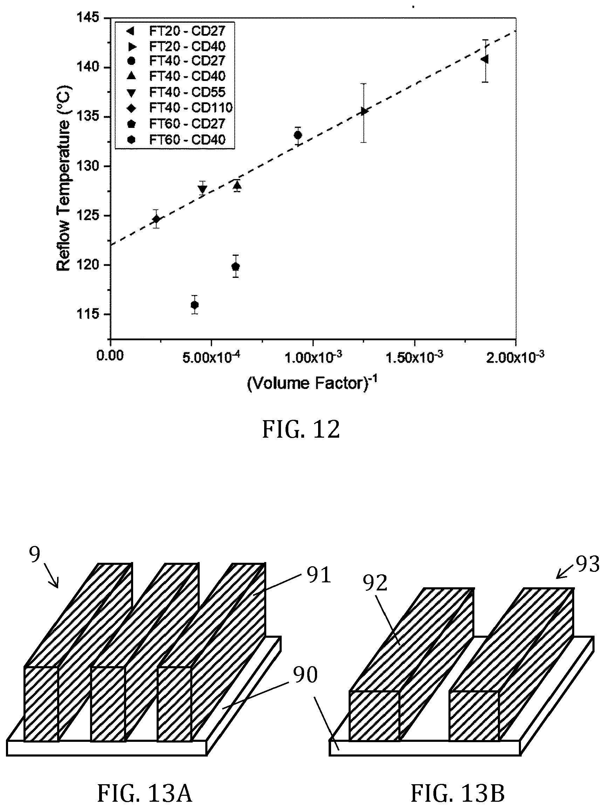

Reference is made to FIG. 12, which is a plot of all determined $T_R$ values, plotted versus the inverse of their respective Volume Factors.

A linear trend is found for resist structures having a predetermined height of 20 and 40 nm, versus the inverse of the volume factor. However, it may be observed that the data points for the resist structures having a height of 60 nm deviate from this linear trend. This discrepancy can be understood when looking at a specific case.

In the case of resist structures having a height of 40 nm and a width of 40 nm (triangle pointing up), as well as resist structures having a height of 60 nm and a width of 27 nm (pentagon), we obtain a volume scaling factor that is very similar (1600, and 1620 nm$^2$ respectively). This means that, assuming an equal length, both resist structures practically have the same volume. Despite having this same volume, the $T_R$ of the resist structures having a width of 40 nm is close to 10°C higher than the $T_R$ of the resist structures having a width of 27 nm. This indicates that not just volume, but also the surface areas of the resist structure, and its interactions with the environment, play a role in the determination of $T_R$. After all, if the $T_R$ was only dependent on the volume, that would mean that any interaction of the resist structure with its environment would have no significant impact.

Reference is made to FIG. 13A, which shows an entity 9 comprising resist structures 91, i.e., resist line structures, having a height of 60 nm and a width of 27 nm, on an underlayer material 90. Simultaneously, reference is made to FIG.

13B, which shows an entity 93 comprising resist structures 92 having a height of 40 nm and a width of 40 nm, on an underlayer material 90. The aspect ratio of the resist structures 91 in FIG. 13A is larger than the aspect ratio of the resist structures 92 in FIG. 13B. The interface area between the resist structures 91 and the underlayer material 90 in FIG. 13A is smaller than the interface area between the resist structures 92 and the underlayer material 90 in FIG. 13B. Thus, different resist structures 91, 92 having the same volume may not have the same interface area, hence not the same reflow temperature. Thus, a correction factor preferably accounts for the difference in aspect ratio, and the corresponding difference between the area in contact with the underlayer material and the area in contact with the ambient. The area of the resist structure in contact with the ambient may be calculated as follows:

$$\text{Area (ambient)} = \text{width} \times \text{length} + 2 \times \text{height} \times \text{length} \qquad \text{(eq. 10)}$$

The area of the resist structure in contact with the underlayer may be calculated as follows:

$$\text{Area (underlayer)} = \text{width} \times \text{length} \qquad \text{(eq. 11)}$$

The ratio of the area of the resist structure in contact with the ambient to the area of the resist structure in contact with the underlayer may then be calculated as follows:

$$\text{Area Ratio} = \text{Area (ambient)} / \text{Area (underlayer)}$$

$$= 1 + (2 \times \text{height} / \text{width}) \qquad \text{(eq. 12)}$$

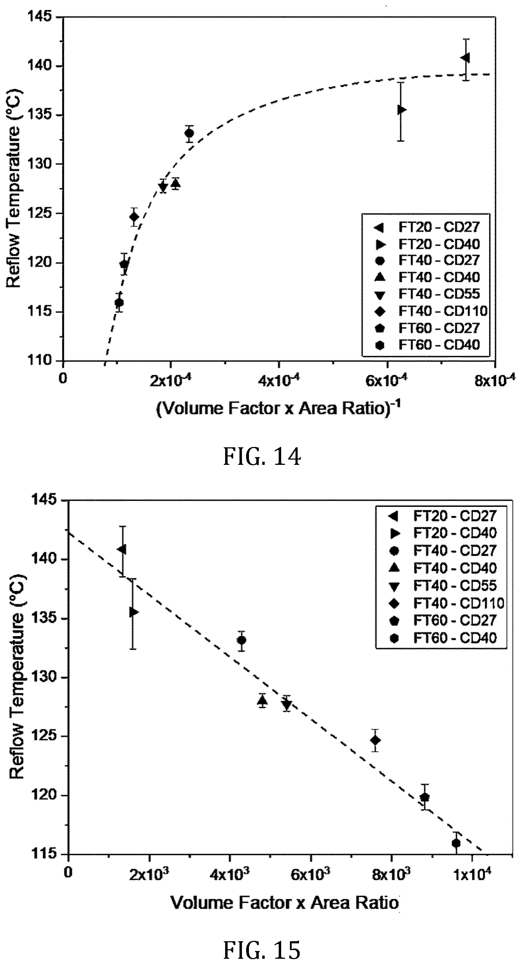

Reference is made to FIG. 14 and FIG. 15, which are plots of the reflow temperature determined for the eight different sets of entities as dependent on the inverse of the product of the Volume Factor and the Area Ratio, and as dependent on the product of the Volume Factor and the Area Ratio, respectively. The good fit obtained in FIG. 14 and FIG. 15 indicates that the reflow temperature is dependent on both volume of the resist structure and the ratio of the area of the resist structure in contact with the ambient to the area of the resist structure in contact with the underlayer material. Indeed, when plotting the $T_R$ versus the product of the VF and area correction factor instead of the inverse, a linear correlation between $T_R$ and its influencing factors is obtained. The linearity of the fit makes it easy to predict a $T_R$ for a given height and width for the resist structures, provided a calibration curve for that specific resist structure and underlayer material is available. Furthermore, as the $T_R$ is not just dependent on volume, but also on the area of the resist structure in contact with the underlayer material, and thus also dependent on the interactions between the resist structure and the underlayer material, this methodology may be used to investigate resist interfacial interactions based on their reflow temperature. In that case, a good, i.e., strong, interaction between the resist structure and the underlayer material may be expected to result in a higher reflow temperature for a larger interface area between the resist structure and the underlayer material. Similarly, a bad, e.g., weak, resist-underlayer interaction may result a drop in the $T_R$ when the interface area increases.

Therefore, the method of the present invention may, for example, be used for screening of good combinations of resist structure and underlayer material, or investigating the effect of changing the resist additives (e.g., the photo-acid generator and quencher), polymer pendant groups or the polymer backbone on the resist-underlayer interfacial interactions. Furthermore, the method of the present invention may be used in a FAB environment to assess the impact of going to smaller resist height or width on the reflow temperature and thus also the glass transition temperature, to assess the impact on the acid-diffusion process and resulting (unbiased) LER/LWR.

It is to be understood that although preferred embodiments, specific constructions and configurations, as well as materials, have been discussed herein for devices according to the present invention, various changes or modifications in form and detail may be made without departing from the scope of this invention. For example, any formulas given above are merely representative of procedures that may be used. Functionality may be added or deleted from the block diagrams and operations may be interchanged among functional blocks. Steps may be added or deleted to methods described within the scope of the present invention.

## Claims

1. A method for determining a value representative of a state transition temperature of a resist structure (91, 92),

formed of a resist material and having predetermined dimensions, on an underlayer material (90), the method comprising:

a) receiving (104) data representing a correlation between a second value for a measure representative of a spatial feature of at least one resist structure (91, 92) of each of a plurality of entities (9, 93) after applying a heat treatment, and a temperature at which said heat treatment is applied,
each entity (9, 93) comprising the at least one resist structure (91, 92), formed of the resist material and having said predetermined dimensions before said heat treatment, on the underlayer material (90), and wherein said measure has a first value before said heat treatment, and
b) determining (105), from said correlation, said value representative of the state transition temperature, for which, when the heat treatment would be performed at such temperature, said second value differs by a predetermined amount from said first value.

2. The method according to claim 1, wherein the spatial feature is a roughness of the resist structure (91, 92).

3. The method according to claim 2, wherein the measure representative of the spatial feature is a correlation length for a line width roughness or for a line edge roughness.

4. The method according to any of the previous claims, wherein determining said value representative of the state transition temperature comprises fitting an exponential growth function to the correlation between the second value and the temperature at which the heat treatment is applied.

5. The method according to any of the previous claims, wherein the resist material is a chemically amplified resist.

6. The method according to any of the previous claims, wherein receiving data comprises,

a') obtaining (101) the plurality of entities (9, 93), wherein each entity (9, 93) comprises at least one resist structure (91, 92), formed of the resist material and having said predetermined dimensions, on the underlayer material (90), wherein the measure representative of the spatial feature of the at least one resist structure (91, 92) has the first value before the heat treatment,
a") applying (102) the heat treatment to the plurality of entities (9, 93), wherein a temperature at which the heat treatment is applied is different for each entity (9, 93) of the plurality of entities (9, 93),
a''') determining (103) the second value for said measure representative of the spatial feature after said heat treatment for the at least one resist structure (91, 92) of each of the plurality of entities (9, 93), so as to obtain said correlation between the second value and the temperature at which the heat treatment is applied.

7. The method according to claim 6, wherein, in step a'''), critical-dimension scanning electron microscopy is performed on a portion of each of the plurality of entities (9, 93) comprising said at least one resist structure (91, 92), wherein determining the second value comprises determining a power spectral density from an image obtained from said critical-dimension scanning electron microscopy.

8. The method according to any of claims 6 or 7, wherein step a') further comprises forming a reference entity, comprising at least one reference resist structure, formed of the resist material and having said predetermined dimensions, on a reference substrate, and wherein step a''') comprises selecting a portion of the reference entity that comprises the at least one reference resist structure having said predetermined dimensions, and wherein the second value for the at least one resist structure (91, 92) of each of the plurality of entities (9, 93) is determined on a corresponding portion, corresponding to said selected portion of the reference entity, of the each of the plurality of entities (9, 93).

9. A further method for determining a dependency of a value representative of a state transition temperature of a resist structure (91, 92) on an underlayer material (90), on a property of the resist structure (91, 92) or of the underlayer material (90), comprising:

obtaining the value representative of the state transition temperature for each of at least two sets of entities, by performing the method according to any of the previous claims on each of the two sets of entities,
each set comprising a plurality of entities (9, 93), wherein, within each set of entities, each entity (9, 93) comprises at least one resist structure (91, 92) formed of a resist material and having predetermined dimensions, on the underlayer material (90), wherein, amongst different sets of entities (91, 92), said property is different.

10. The further method according to claim 9, wherein said property is one of a dimensional characteristic of the resist structure (91, 92), a composition of the resist structure (91, 92), or the underlayer material (90).

11. The further method according to claim 10, wherein the dimensional characteristic is representative of a product of a volume of the resist structure (91, 92) and a ratio of an exposed area of the resist structure (91, 92) to an interface area of the resist structure (91, 92) with the underlayer material (90).

12. A data processing apparatus comprising means configured for carrying out the method according any of claims 1 to 5, or any of claims 9 to 11 as dependent on any of claims 1 to 5.

13. A computer program comprising instructions which, when the program is executed by a computer, cause the computer to carry out the method according any of claims 1 to 5, or any of claims 9 to 11 as dependent on any of claims 1 to 5.

14. A computer-readable medium having stored thereon the computer program of claim 13.

15. A device comprising:

means for applying a heat treatment to a plurality of entities (9, 93), wherein each entity (9, 93) comprises at least one resist structure (91, 92), formed of a resist material and having predetermined dimensions, on a substrate, wherein a measure representative of a spatial feature of the at least one resist structure (91, 92) has a first value before heat treatment, wherein a temperature at which the heat treatment is applied is different for each entity (9, 93) of the plurality of entities,
means for determining a second value for said measure representative of the spatial feature after said heat treatment for the at least one resist structure (91, 92) of each of the plurality of entities, so as to obtain a correlation between the second value and the temperature at which the heat treatment is applied, and
means for determining, from said correlation, a value representative of a state transition temperature, for which, when the heat treatment would be performed at such temperature, said second value differs by a predetermined amount from said first value.

i) Obtaining (1) at least two sets, each comprising a plurality of entities, wherein a property is different amongst the at least two sets

ii) Determining (2) the value representative of the state transition temperature for each of the at least two sets, by, for each set:

a') Obtaining (101) the plurality of entities

a'') Applying (102) a heat treatment to the plurality of entities, wherein a temperature of the heat treatment is different for each entity

a''') Determining (103) a second value for the plurality of entities, so as to obtain a correlation between the second value and the temperature at which the heat treatment is applied

a) Receiving (104) data representing a correlation between a second value and the temperature of the heat treatment

b) Determining (105) a value representative of the state transition temperature from the correlation

FIG. 1

PSD

$\frac{1}{f}$

FIG. 2A

FIG. 2B

FIG. 3

FIG. 4

FIG. 5

FIG. 6

FIG. 7

FIG. 8

FIG. 9

FIG. 10

FIG. 11

FIG. 12

FIG. 13A                    FIG. 13B

FIG. 14

FIG. 15

Europäisches Patentamt

European Patent Office

Office européen des brevets

# EUROPEAN SEARCH REPORT

**Application Number**

**EP 22 20 0163**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2005/026078 A1 (CHOI SANG-JUN [KR] ET AL) 3 February 2005 (2005-02-03) | 1,5,6, 8-15 | INV. G03F7/20 |
| Y | * paragraph [0003] – paragraph [0061] * * figures 1,2 * | 2-4,7 | G03F7/40 |
| Y | US 7 159 205 B1 (AMBLARD GILLES [US] ET AL) 2 January 2007 (2007-01-02) | 2,3 | |
| A | * column 6, line 33 – column 7, line 10 * * figure 3 * | 1,12-15 | |
| Y | US 2022/068594 A1 (MACK CHRIS [US]) 3 March 2022 (2022-03-03) | 4,7 | |
| A | * paragraph [0170] – paragraph [0172] * * figures 26,27 * | 1,12-15 | |

TECHNICAL FIELDS SEARCHED (IPC)

G03F

The present search report has been drawn up for all claims

| Place of search | Date of completion of the search | Examiner |
|---|---|---|
| Munich | 17 March 2023 | Meixner, Matthias |

EPO FORM 1503 03.82 (P04C01)

## ANNEX TO THE EUROPEAN SEARCH REPORT
## ON EUROPEAN PATENT APPLICATION NO.

EP 22 20 0163

This annex lists the patent family members relating to the patent documents cited in the above-mentioned European search report.
The members are as contained in the European Patent Office EDP file on
The European Patent Office is in no way liable for these particulars which are merely given for the purpose of information.

17-03-2023

| Patent document cited in search report | | Publication date | Patent family member(s) | | Publication date |
|---|---|---|---|---|---|
| US 2005026078 | A1 | 03-02-2005 | DE | 10019282 A1 | 26-10-2000 |
| | | | JP | 3660855 B2 | 15-06-2005 |
| | | | JP | 2000356850 A | 26-12-2000 |
| | | | KR | 20000067806 A | 25-11-2000 |
| | | | US | 6485895 B1 | 26-11-2002 |
| | | | US | 2003054292 A1 | 20-03-2003 |
| | | | US | 2005026078 A1 | 03-02-2005 |
| US 7159205 | B1 | 02-01-2007 | NONE | | |
| US 2022068594 | A1 | 03-03-2022 | NONE | | |

EPO FORM P0459

For more details about this annex : see Official Journal of the European Patent Office, No. 12/82

**EP 4 350 441 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **C. CUTLER et al.** Roughness Power Spectral Density as a Function of Aerial Image and Basic Process / Resist Parameters. *Journal of Photopolymer Science and Technology,* 2019, vol. 32, 779-790

- **V. CONSTANTOUDIS et al.** Line edge roughness and critical dimension variation: Fractal characterization and comparison using model functions. *Journal of Vacuum Science & Technology B: Microelectronics and Nanometer Structures,* 2004, vol. 22, 1974-1981

29